# EUROPÄISCHE PATENTSCHRIFT

(11) **EP 4 139 128 B1**
(45) Veröffentlichungstag und Bekanntmachung des Hinweises auf die Patenterteilung: **27.12.2023**
(21) Anmeldenummer: 20720807.5
(22) Anmeldetag: 20.04.2020
(51) Int. Cl.: C23C 16/01, C23C 16/26

(54) **VERFAHREN UND VORRICHTUNG ZUM TRANSFERIEREN EINER ÜBERTRAGUNGSSCHICHT**
METHOD AND DEVICE FOR TRANSFERRING A TRANSFER LAYER
PROCÉDÉ ET DISPOSITIF PERMETTANT DE TRANSFÉRER UNE COUCHE DE TRANSFERT

(43) Veröffentlichungstag der Anmeldung: 01.03.2023
(73) Patentinhaber: EV Group E. Thallner GmbH, 4782 St. Florian am Inn (AT)
(72) Erfinder: MOKKAPATI, Venkata Raghavendra Subrahmanya Sarma, 4782 St. Florian am Inn (AT); POVAZAY, Boris, 4782 St. Florian am Inn (AT); UHRMANN, Thomas, 4782 St. Florian am Inn (AT)
(74) Vertreter: Schneider, Sascha
(86) Internationale Anmeldenummer: PCT/EP2020/061026
(87) Internationale Veröffentlichungsnummer: WO 2021/213624

(56) Entgegenhaltungen:
- EP-A2- 1 407 831
- WO-A1-2014/108505
- WO-A1-2016/101992
- WO-A1-2016/112975
- CN-B- 104 451 592
- US-A1- 2015 371 848

## Beschreibung

Die Erfindung beschreibt ein Verfahren zum Transferieren einer Übertragungsschicht.

Im Stand der Technik existieren bereits Schichtübertragungsprozesse (eng.: layer transfer processes). Diese Prozesse werden verwendet, um sehr dünne Übertragungsschichten, insbesondere solche mit Dicken im Mikrometer oder sogar Nanometerbereich, von einem Substrat auf ein anderes Substrat, zu transferieren. Sehr viele dieser Übertragungsschichten lassen sich nur auf einer spezifischen ersten Oberfläche erzeugen, die aber nicht gleichzeitig Teil des späteren funktionalen Bauteils sein soll. Daher muss die Übertragungsschicht von der ersten Oberfläche auf eine zweite Oberfläche übertragen werden. WO 2014108505 A1 offenbart eine Sonnenschutzfolie mit mehreren Schichten, wobei mindestens eine der Schichten eine Ladungsträgerschicht ist. WO 2016101992 A1 offenbart ein Verfahren und eine Vorrichtung zur Vorfixierung von Substraten, wobei mindestens eine Substratoberfläche der Substrate in mindestens einem Oberflächenbereich amorphisiert ist. WO 2016112975 A1 offenbart ein Verfahren zum Lösen eines mit einem Trägersubstrats von einem Substratstapel. EP 1407831 A2 offenbart ein Verfahren zur Herstellung eines flexiblen Verpackungsmaterials aus einer ein- oder mehrschichtigen Folie. US 2015371848 A1 offenbart einen nichtlinearen Ionenleiter, der eine Vielzahl von Elektroden umfasst. CN 104451592 B offenbart ein Verfahren zum zerstörungsfreien Übertragen von Graphen von einer Metalloberfläche auf die Oberfläche eines Zielsubstrats. Einer der bekanntesten Schichtübertragungsprozesse in der Halbleiterindustrie ist der SmartCut^{™} Prozess. In diesem Prozess werden Ionen, insbesondere Wasserstoffionen, in ein erstes, oxidiertes einkristallines Substrat geschossen. Die Eindringtiefe der Wasserstoffionen kann durch die kinetische Energie geregelt werden und beträgt typischerweise weniger als 2 Mikrometer. Die Wasserstoffionen verbleiben im ersten Substrat bis das Substrat zu einem zweiten Substrat gebondet wurde. Danach sorgt ein thermischer Prozess dafür, dass sich die Wasserstoffatome zu Wassermolekülen kombinieren und eine Trennung des ersten, oxidierten, einkristallinen Substrats entlang der Fläche, in der sich die Wasserstoffionen angesammelt haben, erfolgt. Man erhält eine Dreischichtenstruktur, bei der das Oxid zwischen zwei anderen Materialien, meistens Silizium eingeschlossen ist.

Seit einigen Jahren wird in der Industrie versucht, Graphen großflächig herzustellen. Im Stand der Technik existieren mehrere Verfahren zur Herstellung von Graphen. Graphenflocken können bereits im industriellen Tonnenmaßstab hergestellt werden. Diese Graphenflocken sind für die Halbleiterindustrie allerdings von untergeordneter Bedeutung, da sie viel zu klein sind und vorwiegend durch nasschemische Prozesse, insbesondere in Lösung, und nicht auf Substratoberflächen entstehen. Angestrebt wird die Herstellung einer Graphenschicht entweder auf Wafer Level, d.h. über die gesamte Fläche eines Wafers oder aber gezielt an einer bereits vorhandenen Topologie eines Wafers. Am aussichtsreichsten scheint aber die Herstellung einer Graphenschicht auf Wafer Level zu sein.

Es ist daher die Aufgabe der vorliegenden Erfindung, die Nachteile des Stands der Technik zu beseitigen und ein verbessertes Verfahren bzw. eine verbesserte Vorrichtung zur Übertragung einer Übertragungsschicht anzugeben. Es ist insbesondere die Aufgabe der vorliegenden Erfindung dafür zu sorgen, dass die Übertragungsschicht nicht, insbesondere nicht durch hochenergetische Ionen, zerstört beziehungsweise beschädigt wird.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Gegenstand der Erfindung ist ein Verfahren zur Übertragung einer Übertragungsschicht, insbesondere einer Graphenschicht, von einem Substrat, insbesondere von einem Wachstumssubstrat, auf ein Trägersubstrat, wobei die Übertragung durch eine elektromagnetische Kraft erfolgt.

Gegenstand der Erfindung ist weiterhin eine Vorrichtung zur Übertragung einer Übertragungsschicht, insbesondere einer Graphenschicht, von einem Substrat, insbesondere von einem Wachstumssubstrat, auf ein Trägersubstrat, wobei die Übertragungsschicht durch eine elektromagnetische Kraft übertragbar ist.

Die elektromagnetische Kraft ist vorzugsweise eine elektrostatische Kraft, welche zwischen Ionen im Trägersubstrat und der entsprechend gegenpolig geladenen Übertragungsschicht, insbesondere der Graphenschicht, wirkt. Vorzugsweise sind die Ionen im Trägersubstrat positiv und die Übertragungsschicht negativ geladen.

Gemäß der Erfindung ist vorgesehen, dass
- die Übertragungsschicht und/oder das Substrat mit negativen Ladungsträgern geladen wird,
- das Trägersubstrat mit Ionen geladen wird, wobei die Ionen entgegengesetzt zu den negativen Ladungsträgern geladen sind,
- zwischen der Übertragungsschicht und/oder dem Substrat und dem Trägersubstrat aufgrund der unterschiedlich geladenen Ionen und den negativen Ladungsträgern die Kraft entsteht.

Bevorzugt ist weiterhin vorgesehen, dass das Trägersubstrat eine Folie aufweist, wobei die Folie in einen Rahmen gespannt ist und wobei die Folie die Übertragungsschicht aufnimmt.

Bevorzugt weist die Übertragungsschicht eine Graphenschicht auf.

Bevorzugt weist die Vorrichtung eine Kammer, wobei in der Kammer ein Substrathalter angeordnet ist, wobei der Substrathalter eine elektrisch leitende Verbindung zum Substrat, insbesondere zum Wachstumssubstrat, herstellt.

Im weiteren Verlauf des Textes wird unter der Übertragungsschicht, insbesondere der Graphenschicht, diejenige Schicht auf dem Substrat, insbesondere dem Wachstumssubstrat, verstanden, die auf das Trägersubstrat übertragen werden soll. Insbesondere ist die Übertragungsschicht auf dem Wachstumssubstrat gezüchtet worden.

Die Rauheit der Oberfläche des Wachstumssubstrats sollte bevorzugt möglichst gering sein, um die Herstellung der Übertragungsschicht zu ermöglichen. Besonders dünne Übertragungsschichten, insbesondere Graphenschichten, werden auf sehr ebenen, reinen Oberflächen gezüchtet.

Die Rauheit wird entweder als mittlere Rauheit, quadratische Rauheit oder als gemittelte Rautiefe angegeben. Die ermittelten Werte für die mittlere Rauheit, die quadratische Rauheit und die gemittelte Rautiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rautiefe zu verstehen.

Die Rauheit der Oberfläche des Substrats, insbesondere des Wachstumssubstrats, ist bevorzugt kleiner als 100 µm, vorzugsweise kleiner als 10 µm, noch bevorzugter kleiner als 1 µm, am bevorzugtesten kleiner als 100nm, am allerbevorzugtesten kleiner als 10nm.

Die Oberfläche des Substrats, insbesondere des Wachstumssubstrats, ist bevorzugt einkristallin.

In einer bevorzugten erfindungsgemäßen Ausführungsform weist das Substrat, insbesondere das Wachstumssubtrat, ein erstes Material auf, das mit einem zweiten Material für eine Züchtung der Übertragungsschicht beschichtet wird. Dieses zweite Material wird auch als Wachstumsschicht bezeichnet. Das Substrat, insbesondere das Wachstumssubstrat, ist in diesem Fall ein Verbund aus dem ersten Material und der darauf abgeschiedenen Wachstumsschicht.

Sehr oft stehen die gewünschten Materialien für das Wachstumssubstrat nicht als Einkristalle zur Verfügung bzw. können schwer oder gar nicht als massive Einkristalle gezüchtet werden. In so einem Fall ist es vorteilhaft, wenn man die notwendigen Materialien mit Hilfe der Dünnschichttechnik als einkristalline, dünne Schichten züchten kann.

In einer noch bevorzugteren, erfindungsgemäßen Ausführungsform ist das gesamte Wachstumssubstrat ein Einkristall.

In einer alternativen erfindungsgemäßen Ausführungsform wird zumindest die Oberfläche des Wachstumssubstrats vor der Züchtung der Übertragungsschicht rekristallisiert, sofern die Oberfläche polykristallin ist. Die Rekristallisation führt in den meisten Fällen zu einer Vergröberung der Kornstruktur, wahrscheinlich aber nicht zu einem Einkristall und ist daher eine weniger bevorzugte, erfindungsgemäße Methode.

Bevorzugt ist weiterhin vorgesehen, dass
- die Übertragungsschicht mit dem Trägersubstrat kontaktiert wird, und
- wobei die Ionen im Trägersubstrat in der Nähe der Übertragungsschicht konzentriert werden, so dass die Übertragungsschicht von dem Substrat, insbesondere dem Wachstumssubstrat, abgelöst wird und am Trägersubstrat haftet.

Das Verfahren zum Übertragen der Übertragungsschicht erlaubt somit vorteilhaft ein einfaches und effizientes Übertragen der Übertragungsschicht von der Oberfläche des Substrats auf die Oberfläche des Trägersubstrats, insbesondere das Übertragen von einer Herstellungsoberfläche auf eine Transportoberfläche. Das Ablösen wird durch das Wirken von Ionen, insbesondere von Wasserstoffionen, ermöglicht, indem die Adhäsion zwischen der Wachstumsschicht und der Übertragungsschicht reduziert wird, da die Ionen eine anziehende Kraft auf die Übertragungsschicht ausüben.

Das Trägersubstrat wird bevorzugt mit der Übertragungsschicht kontaktiert, sodass vorteilhaft keine Relativbewegung zwischen den kontaktierten Flächen mehr möglich ist. Vor einer Kontaktierung werden die Übertragungsschicht und das Trägersubstrat zueinander, insbesondere durch eine Ausrichtung von jeweiligen Substrathaltern, ausgerichtet. Zur Ausrichtung werden insbesondere Ausrichtungsmarken, welche auf dem Substrat und/oder der Übertragungsschicht und/oder dem Trägersubstrat angebracht sind, zur möglichst exakten Ausrichtung verwendet.

Folglich wird die Übertragung der Übertragungsschicht auf das Trägersubstrat vorteilhaft einfach und effizient ermöglicht. Besonders vorteilhaft wird die Übertragungsschicht nicht durch das Einwirken der Ionen beschädigt beziehungsweise nicht zerstört. Dabei ist bevorzugt das Erzeugen beziehungsweise Züchten der Übertragungsschicht zuvor auf dem Wachstumssubstrat durchgeführt worden. Somit kann nun vorteilhaft die Übertragungsschicht vom Ort ihrer Erzeugung beziehungsweise ihrer Züchtung auf dem Wachstumssubstrat, gelöst werden und auf dem Trägersubstrat angeordnet werden.

In einer besonders bevorzugten Ausführungsform ist vorgesehen, dass die Übertragungsschicht eine Graphenschicht aufweist. Die Graphenschicht wurde dabei vorzugsweise auf der Wachstumsschicht erzeugt, insbesondere abgeschieden.

### Wachstumssubstrat

Unter einem Wachstumssubstrat versteht man ein Substrat, auf dem die Übertragungsschicht erzeugt bzw. gezüchtet wird. Das Wachstumssubstrat kann aus einem einzigen Material bestehen. Denkbar wäre beispielsweise die Verwendung einer Kupfer- oder Nickelplatte als Wachstumssubtrat.

In einer anderen erfindungsgemäßen Ausführungsform ist das Wachstumssubstrat ein Substrat aus einem ersten Material, auf dem eine Schicht aus einem zweiten Material erzeugt wurde. Diese Schicht kann als Wachstumsschicht bezeichnet werden. Denkbar wäre beispielsweise die Verwendung eines Silizium, Glas oder Saphirwafers, auf dem eine Kupferschicht aufgedampft wurde. Derartig erzeugte Kupferschichten können insbesondere einkristallin hergestellt werden. Sehr oft ist es daher einfacher, ein beliebiges Substrat als Wachstumssubtrat zu verwenden, das dann mit einer einkristallinen Wachstumsschicht beschichtet wird.

Zumindest die Oberfläche des Wachstumssubstrats, auf der die Übertragungsschicht gezüchtet wird, sollte einkristallin sein. Vorzugsweise wird das Wachstumssubstrat daher bereits einkristallin hergestellt. Sollte die Oberfläche nicht einkristallin sein, wird sie vorzugsweise mit Hilfe entsprechender Methoden, vorzugsweise mit einer Rekristallisation, dem einkristallinen Zustand zumindest so nahe wie möglich gebracht.

Im dieser Offenbarung werden die Begriffe Wachstumsschicht und Wachstumssubstrat synonym verwendet. Insbesondere wird zumeist der Ausdruck Wachstumssubstrat verwendet.

Das Material des Wachstumssubstrats ist grundsätzlich nicht eingeschränkt sondern richtet sich nach der zu züchtenden Übertragungsschicht. Nicht jede Art von Übertragungsschicht kann auf jedem Material eines Wachstumssubstrats gezüchtet werden. Ein Wachstumssubstrat kann daher grundsätzlich ein Elektrikum, ein Dielektrikum, eine Halbleiter oder ein Supraleiter sein.

### Übertragungsschicht

Die Übertragungsschicht kann aus einem einzigen Material oder aus mehreren Materialien bestehen.

Insbesondere kann es sich bei der Übertragungsschicht um einen Serienverbund von unterschiedlichen Schichten handeln. In dieser Offenbarung wird der der Serienverbund von Schichten auch als Übertragungsschicht bezeichnet.

In einer besonders bevorzugten erfindungsgemäßen Ausführungsform handelt es sich bei der Übertragungsschicht um eine atomare bzw. molekulare Schicht. Diese Schicht wird auch als 2D Schicht oder 2D Struktur bezeichnet.

In einer ganz besonders bevorzugten erfindungsgemäßen Ausführungsform handelt es sich bei der Übertragungsschicht um eine Graphenschicht.

Das erfindungsgemäße Verfahren kann auf jede Art von Übertragungsschicht angewandt werden. Die Übertragungsschicht ist aber vorzugsweise eine sehr dünne Schicht. Die Dicke der Übertragungsschicht ist kleiner als 1mm, vorzugsweise kleiner als 1 µm, noch bevorzugter kleiner als 100nm, am bevorzugtesten kleiner als 1nm, am allerbevorzugtesten handelt es sich um eine monoatomare bzw. monomolekulare Schicht.

Die Übertragungsschicht besteht vorzugsweise aus einer der folgenden Materialklassen bzw. Materialien.
- 2D Schichtmaterial, insbesondere
   o Graphen
   o Graphyne
   o Borophene
   o Germanene
   ∘ Silicene
   ∘ Si₂BN
   ∘ Gallenene
   ∘ Stanene
   ∘ Plumbene
   ∘ Phosphorene
   ∘ Antimonene
   ∘ Bismuthene
- 2D Suprakristalle
- Verbindungen
   ∘ Graphane
   ∘ Boronitren
   ∘ Borocarbonitride
   ∘ Germanane
   ∘ Germaniumphosphid
   ∘ Übergangsmetaldichalcogenide
   ∘ MXenes
- Lagenmaterialien mit unterschiedlicher Elementzusammensetzung, insbesondere
   ∘ MoS2, WS2, MoSe2, hBN, Ti4N3, Ti4AlN3
- Van der Waals Hetereostrukturen, insbesondere
   ∘ MoS2-G; MoS2-hBN, MoS2-hBN-G
- Metall, insbesondere
   ∘ Cu, Ag, Au, Al, Fe, Ni, Co, Pt, W, Cr, Pb, Ti, Ta, Zn, Sn
- Halbleiter, insbesondere
   ∘ Ge, Si, Alpha-Sn, B, Se, Te,
- Verbindungshalbleiter, insbesondere
   ∘ GaAs, GaN, InP, InxGal-xN, InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGal-xAs, GaS, GaSe, GaTe, InS, InSe, InTe, CuInSe2, CuInS2, CuInGaS2, SiC, SiGe
- Keramik
- Polymer
- Weitere Materialien
   ∘ MnO₂
   ∘ TBAₓH(_{1.07-x})Ti_{1.73}O₄*H2O
   ∘ CoO₂⁻
   ∘ TBAₓH₍₁₋ₓ₎Ca₂Nb₃O₁₀
   ∘ Bi₂SrTa₂O₉
   ∘ Cs₄W₁₁O₃₆²⁻
   ∘ Ni(OH)_{5/3}DS_{1/3}
   ∘ Eu(OH)_{2.5}(DS)_{0.5}
   ∘ Co_{2/3}Fe_{1/3}(OH)₂^{1/3+}
   ∘ [Cu₂Br(IN₂)]ₙ]

### Trägersubstrat

Das Trägersubstrat kann aus jedem beliebigen Material bestehen, welches einen Durchgang von Ionen, insbesondere Wasserstoffionen, erlaubt. Das Material des Trägersubstrats ist vorzugsweise ein Polymer, insbesondere ein Polymer auf Kohlenstoffbasis.

In einer besonderen erfindungsgemäßen Ausführungsform handelt es sich bei dem Trägersubstrat um ein zusammengesetztes Bauteil aus einer Folie und einem Rahmen, auf dem die Folie aufgespannt ist.

In einer anderen Ausführungsform handelt es sich bei dem Trägersubstrat um ein massives Polymersubstrat, das nicht unterstützt wird.

Erfindungsgemäß wird ein Transport, insbesondere eine Diffusion, der Ionen, vorzugsweise Wasserstoffionen, durch ein Polymer besonders begünstigt. Ein elektrisches Feld beschleunigt die Ionen und ist auch innerhalb des Polymers aufrecht, wenn auch geschwächt, da es sich bei den meisten Polymeren um Dielektrika handelt, die elektrische Felder zwar durch Orientierungs- und Verschiebungspolarisation schwächen, sie aber nicht gänzlich abbauen.

Das Trägersubstrat ist insbesondere dazu geeignet, die Ionen in der Nähe der Übertragungsschicht ansammeln zu können.

### Vorrichtung

Die erfindungsgemäße Vorrichtung weist bevorzugt eine Kammer auf, in der die Übertragungsschicht auf dem Substrat mit dem Trägersubstrat in Kontakt gebracht wird. Vorzugsweise handelt es sich bei der Vorrichtung um einen Bonder.

Die Vorrichtung verfügt bevorzugt über mindestens ein Mittel zur Erzeugung von Ionen. Vorzugsweise erzeugt dieses Mittel elektromagnetische Strahlung, ganz besonders bevorzugt UV-Strahlung, Röntgenstrahlung und/oder Gammastrahlung. Eine Quelle elektromagnetischer Strahlen kann sich entweder in der Kammer oder außerhalb der Kammer befinden. Befindet sich die Quelle außerhalb der Kammer, werden die Strahlen über ein Glasfenster in die Kammer gestrahlt.

Die Vorrichtung verfügt bevorzugt über mindestens ein Ventil, um ein Gas oder ein Gasgemisch in die Kammer zu leiten und/oder diese zu evakuieren. Vorzugsweise verfügt die Vorrichtung über mindestens ein zweites Ventil oder einen Rohrleitungsanschluss, um das Gas oder das Gasgemisch aus der Kammer zu entfernen, insbesondere abzupumpen.

In einer anderen bevorzugt erfindungsgemäßen Ausführungsform können die Ionen auch außerhalb der Kammer erzeugt und in die Kammer eingeleitet werden. Denkbar wäre auch die Verwendung einer Ionenkanone, welche die Ionen erzeugt.

Die Vorrichtung verfügt bevorzugt mindestens einen unteren Substrathalter, auf dem das Substrat, insbesondere das Wachstumssubstrat, fixiert werden kann. Der untere Substrathalter besitzt Bauteile, mit deren Hilfe das Substrat auf Potential gesetzt werden kann. Vorzugsweise ist der Substrathalter selbst aus elektrisch leitfähigem Material hergestellt.

Handelt es sich beim Substrat um ein vollvoluminöses elektrisch leitfähiges Substrat, beispielsweise eine Kupferplatte, dann reicht der Kontakt zum Substrathalter aus, um das Substrat über den leitfähigen Substrathalter auf Potential zu setzen. Denkbar wäre auch ein Substrathalter, der beispielsweise über, insbesondere bewegliche, Kontaktierungselemente verfügt, welche auf Potential gesetzt werden können. Diese Kontaktierungselemente können dann das Substrat kontaktieren und es auf Potential setzen. Der Substrathalter ist vorzugsweise durch dielektrische Bauteile von der Kammer elektrisch isoliert.

Die Vorrichtung verfügt insbesondere über eine Isolierung, mit deren Hilfe die Peripherie des Substrats elektrisch von der Umgebung isoliert werden kann, um zu verhindern, dass die erzeugten Ionen das Substrat seitlich erreichen und eindringen.

Vorzugsweise existiert in der Vorrichtung eine Elektrode, die dem Substrathalter insbesondere gegenüber liegt. Da sich der Substrathalter vorzugsweise an der Unterseite der Kammer befindet, befindet sich die Elektrode vorzugsweise an der Oberseite. Substrathalter und Elektrode können auf unterschiedliche Potentiale gesetzt werden und bauen zwischen sich eine elektrische Spannung auf. Der Aufbau der Spannung führt zur Ausbildung eines erfindungsgemäßen elektrischen Feldes, das die in der Kammer erzeugten Ionen in Richtung des Substrathalters beschleunigt, bzw. sie beim Durchgang durch das Trägersubstrat unterstützt.

Denkbar ist auch, dass auf die Verwendung einer eigenen Elektrode verzichtet wird, und die Kammer bzw. die Wandung der Kammer auf potential gesetzt wird und so als Elektrode wirkt.

Die Vorrichtung verfügt über eine Spannungsquelle, mit deren Hilfe das elektrische Feld erzeugt werden kann. Die Spannung liegt zwischen 0V und 10000 Volt, bevorzugter zwischen 0V und 1000V, am bevorzugtesten zwischen 0V und 500V, am allerbevorzugtesten zwischen 0V und 100V.

Die Kammer kann insbesondere geheizt werden. Die Temperatur kann zur Steuerung der Ionisierung des Gases bzw. des Gasgemisches dienen. Die Temperatur liegt insbesondere zwischen 20°C und 1000°C, vorzugsweise zwischen 20°C und 500°C, noch bevorzugter zwischen 20°C und 250°C, am bevorzugtesten zwischen 20°C und 200°C, am allerbevorzugtesten um die 130°C.

### Verfahren

In dem erfindungsgemäßen Verfahren kann bevorzugt das verwendete Gas zu Kationen, also positiv geladenen Teilchen, ionisiert werden. Dementsprechend sind der Substrathalter und/oder das Substrat, insbesondere das Wachstumssubstrat, und/oder die Übertragungsschicht negativ geladen. Sollten Anionen, also negativ geladene Ionen, verwendet werden, ist die Polung des Substrathalters und/oder des Substrats und/oder der Übertragungsschicht entsprechend positiv.

Durch den erwähnten Ionisierungsprozess durch UV-Strahlung entstehen hauptsächlich Kationen, also positiv geladene Ionen, so dass der erste Fall durchgehend in der Beschreibung verwendet wird.

In einem **ersten** Verfahrensschritt eines beispielhaften erfindungsgemäßen Verfahrens wird ein Substrat als Wachstumssubstrat zur Verfügung gestellt, das über eine Wachstumsschicht verfügt. Vorzugsweise ist das Wachstumssubstrat die gesamte Wachstumsschicht. Denkbar ist beispielsweise die Verwendung einer Kupferplatte. Denkbar ist auch, dass das Wachstumssubstrat aus einem gewöhnlichen Substrat besteht, welches mit einem Material beschichtet wurde, das als Wachstumsschicht dient.

Beispielsweise könnte ein Siliziumsubstrat, vorzugsweise epitaktisch und monokristallin, mit Kupfer beschichtet werden.

In einem zweiten Verfahrensschritt wird auf der Wachstumsschicht eine Übertragungsschicht erzeugt. Vorzugsweise wird die Übertragungsschicht durch einen CVD oder PVD Prozess hergestellt.

In einem **dritten** Verfahrensschritt wird das Wachstumssubstrat mit der darauf befindlichen Übertragungsschicht in eine Kammer einer erfindungsgemäßen Vorrichtung geladen.

In einem **vierten** Verfahrensschritt wird die Wachstumsschicht mit der Oberfläche eines Trägersubstrats kontaktiert, insbesondere gebondet. Dem Bondvorgang kann ein Ausrichtungsvorgang voran gehen. Bei dem Ausrichtungsvorgang kann es sich um eine mechanische Ausrichtung des Trägersubstrats in Bezug zum Substrat handeln, die recht grob durchgeführt wird.

In einem **fünften** Verfahrensschritt wird ein Gas oder ein Gasgemisch, vorzugsweise Wasserstoff, in die Kammer eingelassen.

In einem **sechsten** Verfahrensschritt wird das Gas oder mindestens eine Komponente des Gasgemisches ionisiert. Die Ionisierung erfolgt dabei vorzugsweise mit Hilfe elektromagnetischer Strahlung, vorzugsweise mit UV-Strahlung. Die Strahlungsquelle befindet sich dabei entweder innerhalb der Kammer und/oder außerhalb. Befindet sich die Strahlungsquelle außerhalb der Kammer, gelangt die Strahlung durch ein Fenster in die Kammer.

In einem siebten Verfahrensschritt wird eine Potentialdifferent zwischen der Wachstumsschicht und einer Elektrode, insbesondere dem Gehäuse der Kammer, erzeugt. Die Potentialdifferenz führt zu einem elektrischen Feld, welches die positiven Ionen in Richtung des negativ geladenen Wachstumssubstrats beschleunigt.

In einer bevorzugten erfindungsgemäßen Ausführungsform finden der sechste und der siebte Verfahrensschritte zumindest teilweise gleichzeitig statt.

Die Ionen treffen dabei zuerst auf das Trägersubstrat und werden von diesem abgebremst. Die Ionen werden dann vom elektrischen Feld durch das Trägersubstrat getrieben und erreichen die ebenfalls negativ geladene Übertragungsschicht. Die Ionen sammeln sich im Trägersubstrat in der Nähe der Übertragungsschicht. Da die Übertragungsschicht negativ geladen ist, wirkt eine Anziehung zwischen dem, durch die positiven Ionen positiv geladenen Trägersubstrat und der Übertragungsschicht. Insbesondere verhindert eine Isolierung an der Peripherie des Wachstumssubstrats, dass die positiven Ionen in das Wachstumssubstrat eindringen können.

Die Kraft, mit der die Übertragungsschicht vom Substrat, insbesondere dem Wachstumssubstrat, abgezogen werden kann, wird über den Gasdruck und/oder das elektrische Feld eingestellt. Um eine Ablösung zu bewirken, muss eine Energiemenge pro Flächeneinheit, die Energieflächendichte, überwunden werden. Die Energieflächendichte liegt bevorzugt zwischen 0.01 J/m2 und 1000 J/m2, weiter vorzugsweise zwischen 0.1 J/m2 und 800 J/m2, am bevorzugtesten zwischen 1 J/m2 und 500 J/m2, am allerbevorzugtesten zwischen 1 J/m2 und 100 J/m2.

Die Temperatur, bei der die Übertragungsschicht vorzugsweise transferiert wird liegt insbesondere zwischen 20°C und 300°C, vorzugsweise zwischen 50°C und 250°C, noch bevorzugter zwischen 75°C und 200°C, am bevorzugtesten zwischen 100°C und 150°C, am allerbevorzugtesten um die 130°C.

Ein höherer Gasdruck bedeutet eine höhere Ionendichte. Über das elektrische Feld kann gesteuert werden, wie schnell die Ionen bei der Übertragungsschicht ankommen. Der Gasdruck liegt zwischen 0 mPa und 100 mPa, vorzugsweise zwischen 0 mPa und 50 mPa, noch bevorzugter zwischen 0 mPa und 25 mPa, am bevorzugtesten zwischen 0 mPa und 10 mPa, am allerbevorzugtesten um die 1.5 mPa.

In einer besonders bevorzugten Auslegung des Verfahrens liegt der Gasdruck zwischen 10 Pa und 1 MPa (0,1 mbar und 10 mbar), bevorzugt zwischen 20 Pa und 700 Pa (0,2 mbar und 7 mbar), besonders bevorzugt zwischen 25 Pa und 500 Pa (0,25 mbar und 5 mbar), am allerbevorzugtesten um die 30 Pa (0,3 mbar).

In einem **achten** Verfahrensschritt wird das Trägersubstrat zusammen mit der transferierten Übertragungsschicht vom Wachstumssubstrat getrennt. Der Trennungsvorgang erfolgt vorzugsweise schrittweise von mindestens einem Rand durch Abziehen (engl.: peeling). Denkbar ist allerdings auch, dass das Trägersubstrat vollflächig mit der Übertragungsschicht vom Wachstumssubstrat abgehoben wird.

Es ist denkbar, dass sich die Ionen über die Übertragungsschicht hinweg in Richtung des Wachstumssubstrats bewegen und dort reduziert (positive Ionen) werden. Insbesondere bei Wasserstoff führt das dazu, dass sich Wasserstoffgas bildet, welches ein erheblich größeres Volumen besitzt. Die Bildung von Wasserstoffgas an der Grenzfläche zwischen dem Wachstumssubstrat und der Übertragungsschicht kann sich positiv auf die Lösung der Übertragungsschicht vom Wachstumssubstrat auswirken und diese unterstützen. Die Bildung von Wasserstoffgas führt zu einer mechanischen Spannung, welche die Adhäsion der Grenzfläche zwischen Wachstumssubstrat und Übertragungsschicht sehr stark reduzieren kann. Dieser Effekt ist daher in Kombination mit dem oben genannten Effekt der lonenansammlung im Trägersubstrat zu betrachten. Ob dieser Effekt und in welchem Ausmaß dieser Effekt den erfindungsgemäßen, ersten Effekt verbessert hängt von den entsprechenden Parametern ab.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
Figur 1 eine beispielhafte Ausführungsform einer erfindungsgemäßen Vorrichtung,
Figur 2a eine vereinfachte, geschnittene Darstellung der rechten Seite der Vorrichtung in einem ersten Verfahrensschritt eines beispielhaften erfindungsgemäßen Verfahrens,
Figur 2b eine vereinfachte, geschnittene Darstellung der rechten Seite der Vorrichtung in einem zweiten Verfahrensschritt,
Figur 2c eine vereinfachte, geschnittene Darstellung der rechten Seite der Vorrichtung in einem dritten Verfahrensschritt und
Figur 2d eine vereinfachte, geschnittene Darstellung der rechten Seite der Vorrichtung in einem vierten Verfahrensschritt.

In den Figuren sind gleiche Bauteile oder Bauteile mit der gleichen Funktion mit den gleichen Bezugszeichen gekennzeichnet.

Die Figuren sind nicht maßstabsgetreu. Insbesondere wird eine Übertragungsschicht 12 viel dicker dargestellt, als sie in Relation zu einem Wachstumssubstrat 13 oder zu einem Trägersubstrat 10 sein dürfte. Die nicht maßstabsgetreue Darstellung dient alleine der Übersichtlichkeit.

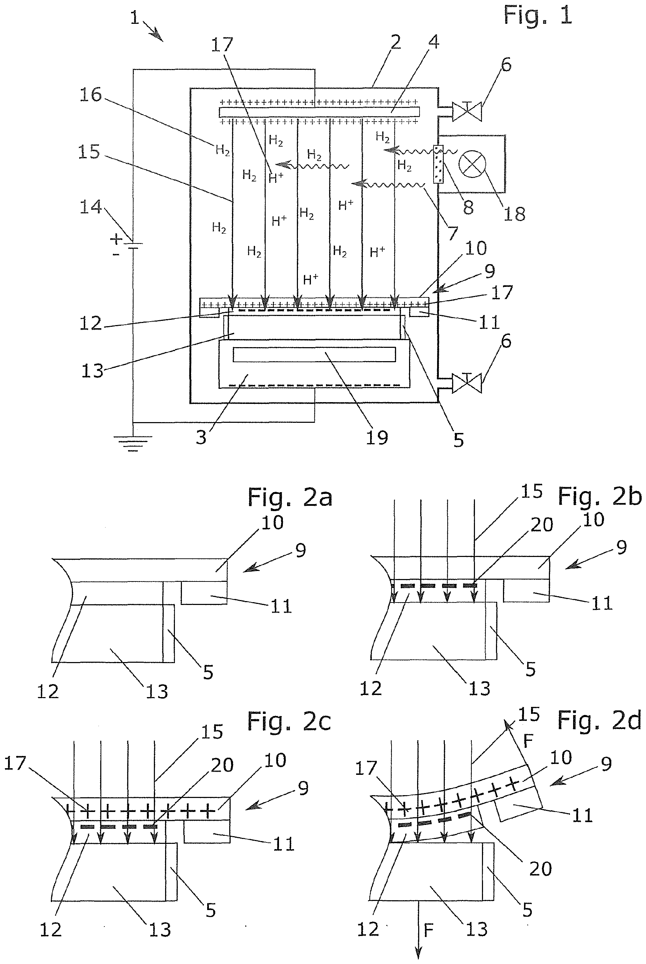

Die **Figur 1** zeigt eine erfindungsgemäße Vorrichtung 1, aufweisend eine Kammer 2, in der sich ein Substrathalter 3 befindet. Der Substrathalter 3 ist elektrisch leitend oder besitzt zumindest eine elektrisch leitende Verbindung zum Wachstumssubstrat 13. Die Kammer 2 verfügt über mindestens ein Ventil 6 über das ein Gas oder ein Gasgemisch 16 eingeleitet werden kann.

Vorzugshalber existiert noch ein zweites Ventil 6, über welches das Gas oder Gasgemisch 16 abgeführt werden kann. Die Kammer 2 verfügt über eine Elektrode 4. Denkbar ist auch, dass eine Wandung der Kammer 2 als Elektrode 4 dient. Der Übersichtlichkeit halber wird die Elektrode 4 als eigenes Bauteil dargestellt.

Die Vorrichtung 1 verfügt über eine Strahlungsquelle 18, mit deren Hilfe die Komponenten des Gases bzw. Gasgemischs 16 zu Ionen 17 ionisiert werden können. Die Strahlungsquelle 18 kann sich innerhalb oder außerhalb der Kammer 2 befinden. Befindet sich die Strahlungsquelle 18 außerhalb der Kammer 2, ermöglicht ein Fenster 8 den Übergang der Strahlung 7 in die Kammer 2.

Die Übertragungsschicht 12 wird auf dem Wachstumssubstrat 13 erzeugt, insbesondere durch einen CVD oder PVD Prozess gezüchtet. Das Wachstumssubstrat 13 wird am Substrathalter 3 fixiert. Das Wachstumssubstrat 13 wird vorzugsweise durch eine Isolierung 5 von der Umgebung abgeschirmt.

Die Übertragungsschicht 12 wird von der anderen Seite von einem Trägersubstrat 9 kontaktiert. Im vorliegenden Fall handelt es sich bei dem Trägersubstrat 9 um eine Folie 10, die in einen Rahmen 11 gespannt ist. Das Trägersubstrat 9 kann aber beliebig geartet sein, solange es den Durchgang der Ionen 17 zur Übertragungsschicht 12 gestattet bzw. solange sich die Ionen 17 im Trägersubstrat 9 (im vorliegenden Fall in der Folie 10) ansammeln. Die Ionen 17 werden nur mehr durch Ihre Ladung dargestellt, da die Verwendung des Formelzeichens die Zeichnung verkomplizieren und unübersichtlicher machen würde.

Durch das angelegte elektrische Feld 15 werden die Ionen 17 in Richtung der Übertragungsschicht 12 beschleunigt und treffen zuerst auf das Trägersubstrat 9. Das elektrische Feld 15 durchdringt das gesamte, insbesondere dielektrische, Trägersubstrat 9 vollständig bis zum Wachstumssubstrat 13. Dadurch werden die Ionen 17 auch noch im Trägersubstrat 9 beschleunigt, müssen sich ihren Weg aber durch Diffusionsprozesse zur Übertragungsschicht 12 bahnen.

Die Ionen 17 sammeln sich im Trägersubstrat in der Nähe der Übertragungsschicht 12. Da das elektrische Feld 15 an der Oberfläche des Wachstumssubstrats 13 (genauer gesagt an der Oberfläche der Übertragungsschicht 12, sofern diese elektrisch ist) endet, ist auch keine Triebkraft mehr vorhanden, die Ionen 17 tiefer in das Wachstumssubstrat 13 zu befördern. Dennoch könnte es einigen Ionen 17 gelingen, bis zum Wachstumssubstrat 13 durchzudringen, insbesondere durch Tunneleffekte. Dort könnten die Ionen 17 wieder reduziert werden und sich insbesondere zu Wasserstoffgas, verbinden. Das Wasserstoffgas kann sich ausdehnen und so die Trennung der Übertragungsschicht 12 von der Seite der Wachstumsschicht 13 aus begünstigen. In diesem Fall besitzt die Vorrichtung 1, insbesondere aber der Substrathalter 3, eine Heizvorrichtung 18, um die Substrate auf Temperatur zu bringen.

Die **Figur 2a** zeigt eine Darstellung der rechten Seite der Vorrichtung in einem ersten Verfahrensschritt eines beispielhaften erfindungsgemäßen Verfahrens, wobei das Trägersubstrat 9 die Übertragungsschicht 12, welche sich auf dem Wachstumssubstrat 13 befindet, kontaktiert.

Die **Figur 2b** zeigt einen zweiten Verfahrensschritt, wobei ein elektrisches Feld 15 angelegt wird, welches dazu führt, dass die Übertragungsschicht 12 negativ geladen wird. Die negativen Ladungsträger 20 wandern in die Oberfläche der Übertragungsschicht 12, sofern die Übertragungsschicht 12 ein Elektrikum ist. Sollte es sich bei der Übertragungsschicht 12 um ein Dielektrikum handeln, sind die negativen Ladungsträger 20 als die negativen Ladungsträger einer Verschiebungs- oder Orientierungspolarisation zu verstehen. Die tatsächlichen negativen Ladungsträger 20 würden sich dann entweder an der Oberfläche der Wachstumsschicht 13 befinden, oder, sollte dieses ebenfalls ein Dielektrikum sein, an der Oberfläche des Substrathalters (nicht eingezeichnet). Die entsprechenden positiven Ladungsträger sind in diesem Fall nicht eingezeichnet. Relevant ist, dass die Oberfläche der Übertragungsschicht 12 negativ geladen ist.

Die **Figur 2c** zeigt einen dritten Verfahrensschritt, wobei Ionen 17, insbesondere Wasserstoffionen, im Trägersubstrat 9 verbleiben und sich an die Übertragungsschicht 12 angenähert haben. Auf Grund des unterschiedlichen Vorzeichens zwischen den positiv geladenen Ionen 17 und der negativ geladenen Übertragungsschicht 12 herrscht eine Anziehung zwischen beiden.

Die **Figur 2d** zeigt einen vierten Verfahrensschritt, wobei die Übertragungsschicht 12, die am Trägersubstrat 9 (im speziellen Fall an der Folie 10) haftet, vom Wachstumssubstrat 13 durch einen Abziehprozess vom Rand her entfernt wird.

### Bezugszeichenliste

- 1: Vorrichtung
- 2: Kammer
- 3: Substrathalter/Elektrode
- 4: Elektrode
- 5: Isolierung
- 6: Ventil
- 7: Strahlung
- 8: Fenster
- 9: Trägersubstrat
- 10: Folie
- 11: Rahmen
- 12: Übertragungsschicht
- 13: Wachstumssubstrat
- 14: Spannungsquelle
- 15: Elektrische Feldlinien
- 16: Gas
- 17: Ion
- 18: Strahlungsquelle
- 19: Heizvorrichtung
- 20: Negative elektrische Ladung
- F: Kraft

## Patentansprüche

1. Verfahren zur Übertragung einer Übertragungsschicht (12), insbesondere einer Graphenschicht, von einem Substrat (13), insbesondere von einem Wachstumssubstrat (13), auf ein Trägersubstrat (9), **dadurch gekennzeichnet, dass** die Übertragung durch eine elektromagnetische Kraft (F) erfolgt,
**dadurch gekennzeichnet, dass**
- die Übertragungsschicht (12) und/oder das Substrat (13) mit negativen Ladungsträgern (20) geladen wird,
- das Trägersubstrat (9) mit Ionen (17) geladen wird, wobei die Ionen (17) entgegengesetzt zu den negativen Ladungsträgern (20) geladen sind,
- zwischen der Übertragungsschicht (12) und/oder dem Substrat (13) und dem Trägersubstrat (9) aufgrund der unterschiedlich geladenen Ionen (17) und den negativen Ladungsträgern (20) die Kraft (F) entsteht.

2. Verfahren nach Anspruch 1, wobei das Trägersubstrat (9) eine Folie (10) aufweist, wobei die Folie (10) in einen Rahmen (11) gespannt ist und wobei die Folie (10) die Übertragungsschicht (12) aufnimmt.

3. Verfahren nach mindestens einem der vorhergehenden Ansprüche, wobei eine Rauheit einer Oberfläche des Substrats (13), insbesondere des Wachstumssubstrats (13), kleiner als 100 µm ist, vorzugsweise kleiner als 10 µm, noch bevorzugter kleiner als 1 µm, am bevorzugtesten kleiner als 100nm, am allerbevorzugtesten kleiner als 10nm.

4. Verfahren nach mindestens einem der vorhergehenden Ansprüche, wobei eine Oberfläche des Substrats (13), insbesondere des Wachstumssubstrats (13), einkristallin ist.

5. Verfahren nach mindestens einem der vorhergehenden Ansprüche, wobei das Substrat (13), insbesondere das Wachstumssubstrat (13), ein erstes Material aufweist, das mit einem zweiten Material für eine Züchtung der Übertragungsschicht beschichtet wird.

6. Verfahren nach mindestens einem der vorhergehenden Ansprüche, wobei
- die Übertragungsschicht (12) mit dem Trägersubstrat (9) kontaktiert wird, und
- wobei Ionen im Trägersubstrat (9) in der Nähe der Übertragungsschicht (12) konzentriert werden, so dass die Übertragungsschicht (12) von dem Substrat (13, insbesondere dem Wachstumssubstrat (13), abgelöst wird und am Trägersubstrat (9) haftet.

7. Verfahren nach mindestens einem der vorhergehenden Ansprüche, wobei die Kraft (F) zwischen 0.01 J/m2 und 1000 J/m2 liegt, vorzugsweise zwischen 0.1 J/m2 und 800 J/m2, am bevorzugtesten zwischen 1 J/m2 und 500 J/m2, am allerbevorzugtesten zwischen 50 J/m2 und 100 J/m2.

8. Vorrichtung (1) zur Übertragung einer Übertragungsschicht (12) von einem Substrat (13), insbesondere von einem Wachstumssubstrat (13) mit einem Verfahren gemäß mindestens einem der vorhergehenden Ansprüche auf ein Trägersubstrat (9), **dadurch gekennzeichnet, dass** die Übertragungsschicht (12) durch eine elektromagnetische Kraft (F) übertragbar ist.

9. Vorrichtung nach Anspruch 8, aufweisend eine Kammer (2), wobei in der Kammer (2) ein Substrathalter (3) angeordnet ist, wobei der Substrathalter eine elektrisch leitende Verbindung zum Substrat (13), insbesondere zum Wachstumssubstrat (13), herstellt.

## Claims

1. A method for transferring a transfer layer (12), in particular a graphene layer, from a substrate (13), in particular from a growth substrate (13), onto a carrier substrate (9), **characterised in that** the transfer takes place by an electromagnetic force (F), **characterised in that**
- the transfer layer (12) and/or the substrate (13) is charged with negative charge carriers (20),
- the carrier substrate (9) is charged with ions (17), wherein the ions (17) are charged opposite to the negative charge carriers (20),
- the force (F) between the transfer layer (12) and/or the substrate (13) and the carrier substrate (9) arises due to the differently charged ions (17) and the negative charge carriers (20).

2. The method according to claim 1, wherein the carrier substrate (9) comprises a film (10), wherein the film (10) is stretched in a frame (11) and wherein the film (10) accommodates the transfer layer (12).

3. The method according to at least one of the preceding claims, wherein the roughness of a surface of the substrate (13), in particular the growth substrate (13), is less than 100 µm, preferably less than 10 µm, still more preferably less than 1 µm, most preferably less than 100 nm, with utmost preference less than 10 nm.

4. The method according to at least one of the preceding claims, wherein the surface of the substrate (13), in particular the growth substrate (13), is monocrystalline.

5. The method according to at least one of the preceding claims, wherein the substrate (13), in particular the growth substrate (13), comprises a first material, which is coated with a second material for a growth of the transfer layer.

6. The method according to at least one of the preceding claims,
wherein
- the transfer layer (12) is contacted with a carrier substrate (9), and
- wherein ions in the carrier substrate (9) are concentrated close to the transfer layer (12), so that the transfer layer (12) is released from the substrate (13), in particular the growth substrate (13), and adheres to the carrier substrate (9).

7. The method according to at least one of the preceding claims, wherein the force (F) lies between 0.01 J/m² and 1000 J/m², preferably between 0.1 and 800 J/m², most preferably between 1 J/m² and 500 J/m², with utmost preference between 50 J/m² and 100 J/m2.

8. A device (1) for transferring a transfer layer (12) from a substrate (13), in particular from a growth substrate (13), onto a carrier substrate (9) with a method according to at least one of the preceding claims, **characterised in that** the transfer layer (12) can be transferred by an electromagnetic force (F).

9. The device according to claim 8, comprising a chamber (2), wherein a substrate holder (3) is arranged in the chamber (2), wherein the substrate holder produces an electrically conductive connection to the substrate (13), in particular to the growth substrate (13).

## Revendications

1. Procédé de transfert d'une couche de transfert (12), en particulier une couche de graphène, à partir d'un substrat (13), en particulier d'un substrat de croissance (13), sur un substrat porteur (9), **caractérisé en ce que** le transfert s'effectue par une force électromagnétique (F), **caractérisé en ce que**
- la couche de transfert (12) et/ou le substrat (13) est chargé de porteurs de charge (20) négatifs,
- le substrat porteur (9) est chargé d'ions (17), dans lequel les ions (17) sont chargés de manière opposée aux porteurs de charge négatifs (20),
- la force (F) se produit entre la couche de transfert (12) et/ou le substrat (13) et le substrat porteur (9) en raison des ions (17) chargés différemment et des porteurs de charge négatifs (20).

2. Procédé selon la revendication 1, dans lequel le substrat porteur (9) présente un film (10), dans lequel le film (10) est tendu dans un cadre (11) et dans lequel le film (10) reçoit la couche de transfert (12).

3. Procédé selon au moins l'une des revendications précédentes, dans lequel une rugosité d'une surface du substrat (13), en particulier du substrat de croissance (13), est inférieure à 100 µm, de préférence inférieure à 10 µm, plus encore de préférence inférieure à 1 µm, de manière la plus préférée inférieure à 100 nm, de manière préférée entre toutes inférieure à 10 nm.

4. Procédé selon au moins l'une des revendications précédentes, dans lequel une surface du substrat (13), en particulier du substrat de croissance (13), est mono-cristalline.

5. Procédé selon au moins l'une des revendications précédentes, dans lequel le substrat (13), en particulier le substrat de croissance (13), présente un premier matériau qui est revêtu d'un second matériau pour une culture de la couche de transfert.

6. Procédé selon au moins l'une des revendications précédentes, dans lequel
- la couche de transfert (12) est mise en contact avec le substrat porteur (9), et
- dans lequel des ions sont concentrés dans le substrat porteur (9) à proximité de la couche de transfert (12), de façon à ce que la couche de transfert (12) soit séparée du substrat (13), en particulier du substrat de croissance (13), et adhère sur le substrat porteur (9).

7. Procédé selon au moins l'une des revendications précédentes, dans lequel la force (F) fait entre 0,01 J/m² et 1000 J/m², de préférence entre 0,1 J/m² et 800 J/m², de manière la plus préférée entre 1 J/m² et 500 J/m², de manière la plus préférée entre toutes entre 50 J/m² et 100 J/m².

8. Dispositif (1) de transfert d'une couche de transfert (12), à partir d'un substrat (13), en particulier d'un substrat de croissance (13), avec un procédé selon au moins l'une des revendications précédentes sur un substrat porteur (9), **caractérisé en ce que** la couche de transfert (12) peut être transmise par une force électromagnétique (F).

9. Dispositif selon la revendication 8, présentant une chambre (2), dans lequel un support de substrat (3) est disposé dans la chambre (2), dans lequel le support de substrat établit une liaison conductrice d'électricité vers le substrat (13), en particulier vers le substrat de croissance (13).
